# EUROPÄISCHE PATENTSCHRIFT

(11) **EP 2 909 867 B1**
(45) Veröffentlichungstag und Bekanntmachung des Hinweises auf die Patenterteilung: **14.09.2016**
(21) Anmeldenummer: 14747319.3
(22) Anmeldetag: 17.07.2014
(51) Int. Cl.: H01L 35/34

(54) **VERFAHREN ZUM ABSCHEIDEN VON THERMOELEKTRISCHEM MATERIAL**
METHOD FOR DEPOSITION OF THERMOELECTRIC MATERIAL
PROCÉDÉ PERMETTANT LE DÉPÔT D'UN MATÉRIAU THERMOÉLECTRIQUE

(30) Priorität: 14.08.2013 DE 102013108791
(43) Veröffentlichungstag der Anmeldung: 26.08.2015
(73) Patentinhaber: O-Flexx Technologies GmbH, 47059 Duisburg (DE)
(72) Erfinder: SPAN, Gerhard, A-6112 Wattens (AT); IOSAD, Nikolay, 65232 Taunusstein (DE)
(74) Vertreter: Kohlmann, Kai
(86) Internationale Anmeldenummer: PCT/EP2014/065422
(87) Internationale Veröffentlichungsnummer: WO 2015/022143

(56) Entgegenhaltungen:
- JP-A- 2010 040 998
- US-A1- 2011 186 956
- US-A1- 2012 018 681
- US-A1- 2012 235 074

## Beschreibung

Die Erfindung betrifft ein Verfahren zum Abscheiden von thermoelektrischem Material auf einem Substrat.

### Stand der Technik

Thermoelektrische Materialien werden derzeit in erster Linie mit dem Ziel der Umwandlung von Wärme zu Strom und des Kühlens erforscht.
Verschiedene Materialien werden dazu für die Entwicklung von thermoelektrischen Elementen benutzt, insbesondere: Bi, Bi₂Te₃, Bi₂Se₃, Sb₂Se₃ BiSbTe, BiSbSe und ihre Legierungen, PbS, PbSe, PbTe, AgPbSbTe, Cu₂CdSnSe₄, SiGe.

Thermoelektrische Materialien können auf unterschiedlichen Wegen hergestellt werden: kolloidale chemische Synthese von Mikro- und von Nanopartikeln aus einzelnen Materialien oder einer Mischung der Materialien, Vakuumprozesse wie thermisches Verdampfen, Ionen- und Elektronstrahl Verdampfung, Laser-Ablation oder elektrochemische Abscheidung.

Der nachfolgend beschriebene Stand der Technik beschreibt die Herstellung und/oder Abscheidung von thermoelektrischen Materialien:
1. WO 2011022189 A2 - *SYNTHESIS OF SILVER, ANTIMONY, AND TIN DOPED BISMUTH TELLURIDE NANOPARTICLES AND BULK BISMUTH TELLURIDE TO FORM BISMUTH TELLURIDE COMPOSITES* - Dotierte Wismuttellurid Nanopartikel werden in einer unregelmäßigen Form synthetisiert und als Kugeln, Pulver oder Suspension unter Verwendung des nichtwässerigen Syntheseweges hergestellt.
2. CN 101613814 A - *Method for fast preparing n type Bi₂(SeₓTe(₁₋ₓ))₃ thermoelectric material* - Die direkte Abscheidung von elementaren Bi, Se, Te-Pulver wird benutzt, um Bi₂(SeₓTe ₍₁₋ₓ₎)₃ als thermoelektrisches Material herzustellen.
3. WO 2009085089 A1 - *FABRICATION OF NANOVOID-IMBEDDED BISMUTH TELLURIDE WITH LOW DIMENSIONAL SYSTEM* - Es werden Wismut und Tellur Nanokristallite aus der Lösung zusammen mit Nanohohlräumen gefällt und thermisch behandelt. Die Wismuttellurid Nanokristallite liegen als Quantenpunkte, Quantendrähte oder als Quanten Wells vor.
4. US 2011117690 A1 - *Fabrication of Nanovoid-Imbedded Bismuth Telluride with low dimensional system* - Es werden Wismuttellurid Nanopartikel aus kolloidalen Lösungen durch Spin-Coating, Eintauchen und Gießverfahren hergestellt.
5. CN 101200002 A - *Preparing process for P type nanometer BiTe based materials* - es wird eine kolloidale Methode für die Synthese von BiTe Nanopartikeln in einer Lösung beschrieben.
6. WO 2010041146 A2 - *NANOCOMPOSITE THERMOELECTRIC CONVERSION MATERIAL, THERMOELECTRIC CONVERSION ELEMENT INCLUDING THE SAME, AND METHOD OF PRODUCING NANOCOMPOSITE THERMOELECTRIC CONVERSION MATERIAL* - es wird eine kolloidale Synthese von Nanopartikeln in einer Lösung zusammen mit der Herstellung des thermoelektrischen Materials aus einer Mischung von verschiedenen Nanopartikeln beschrieben.
7. JP 2010040998 A - *METHOD FOR MANUFACTURING THERMOELECTRIC CONVERSION MODULE* - es wird das Tintenstrahldrucken zur Herstellung von thermoelektrischen Elementen offenbart. Über die Synthese der thermoelektrischen Materialien finden sich keine Angaben.

Zum Abscheiden von thermoelektrischem Material, insbesondere für die Herstellung von thermoelektrischen Schichten und Elementen, werden sowohl Tintenstrahl- als auch Laserdruckverfahren verwendet. Die damit erreichten thermoelektrischen Eigenschaften des abgeschiedenen Materials sind aber nicht ausreichend. Vor allem ist die erzielbare elektrische Leitfähigkeit im Vergleich zu anderen Herstellungsverfahren zu niedrig, da sowohl beim Tintenstrahldrucken als auch beim Laserdrucken nur ein druckloses Sintern des aufgebrachten Materials erfolgen kann, ohne die Vorteile der Druckverfahren wie Geschwindigkeit und Flexibilität aufzugeben. Eine Nutzung eines elektrisch leitfähigen Binders ermöglicht zwar höhere elektrische Leitfähigkeiten, aber der Binder verändert die thermoelektrischen und mechanischen Eigenschaften des abgeschiedenen thermoelektrischen Materials.

Nach dem Abscheiden des thermoelektrischen Materials auf einem Substrat erfolgt üblicherweise ein thermisches Sintern unter Druck, beispielsweise durch Heißpressen in einer Form, Hochdrucksintern oder SPS, um die elektrischen Leitfähigkeit zwischen benachbarten Partikeln des thermoelektrischen Materials zu gewährleisten. Um die Wärmeleitfähigkeit der gesinterten Schichten zu verringern können zusätzlich poröse oder porenfreie Nanoteilchen hinzugefügt werden, die nicht mit der thermoelektrischen Matrix legieren oder anderweitig reagieren.

Ausgehend von diesem Stand der Technik liegt der Erfindung die Aufgabe zugrunde, ein Verfahren zum Abscheiden von thermoelektrischem Material auf einem Substrat im Wege eines Druckprozesses zu schaffen, bei dem die thermoelektrischen Eigenschaften des abgeschiedenen Materials verbessert sind, insbesondere soll die erzielbare elektrische Leitfähigkeit erhöht werden.

### Überblick

Ein Verfahren zum Abscheiden von thermoelektrischem Material, insbesondere in Form mindestens einer Schicht, eines Films oder eines thermoelektrische Elementes aus kolloidalen Nanopartikeln in Form von kolloidalen Lösungen oder Pulvern wird beschrieben. Die kolloidalen Lösungen (Kolloidsystem mit einem flüssigen Medium) werden im Wege eines Tintenstrahldruckprozesses aufgebracht, während das Pulver im Wege des Laserdruckprozesses aufgebracht wird.

Die kolloidalen Nanopartikel bestehen aus verschiedenen Materialien und umfassen, sind aber nicht begrenzt auf Bi₂Te₃, Bi₂Se₃, ihre Legierungen (Bi₄₀Te₆₀₋ₓSeₓ), undotiert oder mit Sb (Bi₄₀₋ₓSbₓTe₆₀), Sn, Ag oder anderen Atomen dotiert, um eine n- oder p-Dotierung des abgeschiedenen Materials zu erzeugen. Die kolloidalen Nanopartikel sind entweder kugelförmig, kubisch, stangenförmig, drahtähnlich oder in Form einer Tetrapode ("Vierfüßler").

Die oben erwähnten kolloidalen Nanopartikel werden durch kolloidale chemische Prozessführung in wässrigen und nichtwässrigen Medien bereitgestellt und haben auf ihrer Oberfläche eine molekulare Schicht (Monolage) von stabilisierenden organischen oder anorganischen Molekülen, die folgende Verbindungen umfassen, aber nicht darauf begrenzt sind: aliphatische Thiole, Amine und Phosphine. Die molekulare Schicht von stabilisierenden organischen oder anorganischen Molekülen verhindert bei Raumtemperatur die Aggregation und Rekristallisation der oben erwähnten kolloidalen Nanopartikel und stabilisiert dadurch die kolloidalen Lösungen. Das Pulver für den Laserdruckprozess wird aus der kolloidalen Lösung gewonnen, indem man das Lösungsmittel aus der kolloidalen Lösung entfernt, wobei die stabilisierende molekulare Schicht von organischen oder anorganischen Molekülen die Nanopartikel im trockenen Pulver an einer Rekristallisation hindert und eine elektrischen Leitfähigkeit unterbindet. Das Fehlen der elektrischen Leitfähigkeit in einem trockenen Pulver aus den oben erwähnten Nanopartikeln mit stabilisierender monomolekularer Schicht ist die Voraussetzung für eine elektrostatische Aufladung der Nanopartikel auf der Fotorezeptortrommel.

Nachdem das thermoelektrische Material aufgebracht wurde, folgt eine thermische Behandlung (Sintern), um die Leitfähigkeit zwischen den Nanopartikeln in den abgeschiedenen festen Schichten einzustellen. Beim Sintern wird die molekulare Schicht aus stabilisierenden Molekülen thermisch von der Oberfläche der Nanopartikel entfernt, die Nanopartikel sintern zusammen, rekristallisieren und eine elektrische Leitfähigkeit wird zwischen den benachbarten Nanopartikeln und über die gesamten gesinterten Schichten geschaffen.

Um die Wärmeleitfähigkeit des abgeschiedenen thermoelektrischen Materials zu verringern, werden poröse und/oder hohle Nanoteilchen, insbesondere Nanokugeln aus SiO₂, TiO₂, Al₂O₃, Glas oder Quarz, in die kolloidale Lösungen zum Tintenstrahldrucken oder das Pulver zum Laserdrucken beigemengt, sodass nach dem thermischen Sintern diese Nanoteilchen Lücken mit niedriger Wärmeleitfähigkeit innerhalb einer thermoelektrischen Matrix bilden, die aus den gesinterten Nanopartikeln gebildet wird.

### Ausführliche Beschreibung der Erfindung

Die vorliegende Erfindung betrifft eine Methode zum Abscheiden von thermoelektrischem Material auf einem Substrat, insbesondere für die Herstellung von thermoelektrischen Filmen und von Elementen, die auf dem Laser- oder Tintenstrahldrucken basiert, wobei Tinten bzw. Pulver verwendet werden, die Nanopartikel aus verschiedenen Halbleitermaterialien enthalten, die mittels kolloidalen Lösungen (Tintenstrahldrucken) oder Pulvern (Laserjet-Drucken) vorbereitet werden.

Die Substrate für das Drucken bestehen aus, sind aber nicht begrenzt auf Glas, Quarz, Metall, flexible Polymerfolien und steife Platten aus Polymeren.

Die Halbleiter und andere Materialien, die für die Herstellung von Nanopartikel geeignet sind, schließen ein, sind aber nicht begrenzt auf Bi, Bi₂Te₃, Bi₂Se₃, ihre Legierungen, undotiert oder mit Sb, Sn, Ag, Se oder anderen Atomen dotiert; das grundlegende Element der thermoelektrischen Materialien sind Nanopartikel aus den oben beschriebenen Materialien in der Größe von 1 bis 1000 Nanometer. Die Form der Nanopartikel kann variieren und ist nicht beschränkt auf kugelförmig, stangenförmig, würfelförmig, drahtförmig oder auf die Form eines Tetrapods.

Die bevorzugte Synthese von BiTe-Nanopartikeln und der oben beschriebenen Verbindungen kann durch Nieder- oder Hochtemperaturreaktion zwischen den Vorläufersubstanzen in wässrigen oder nicht-wässrigen (organischen) Flüssigkeiten (Lösungsmittel) erfolgen. Derartige Prozesse sind an sich bekannt und beispielsweise aus den nachfolgenden Veröffentlichungen beschrieben:
*8.* Large-Scale Synthesis and Characterization of the Size-Dependent Thermoelectric Properties of Uniformly Sized Bismuth Nanocrystals. Jae Sung Son, Kunsu Park, Mi-Kyung Han, Chanyoung Kang, Sung-Geun Park, Jae-Hee Kim, Woochul Kim, Sung-Jin Kim, and Taeghwan Hyeon. Angew. Chem. Int. Ed. 2011, 50, 1363 -1366*;*
*9.* Development of bismuth tellurium selenide nanoparticles for thermoelectric applications via a chemical synthetic process. Cham Kim, DongHwanKim, YoonSooHan, JongShikChung, SangHaPark, SoonheumPark, Hoyoung Kim. Materials Research Bulletin 46 (2011), P. 407-412*].*

Die durchschnittliche Größe, die Form und die genaue chemische Zusammensetzung der Nanopartikel hängen von der Konzentration der Vorläufersubstanzen, der Temperatur und die Dauer der Reaktion sowie dem Vorhandensein von Zusätzen und Wachstumsmodifizierern ab.

Nachdem die oben beschriebenen Nanopartikel in der gewünschten Größe, Form und der chemischen Zusammensetzung erreicht sind, stoppt die Reaktion und die Nanopartikel werden vom Reaktionsgemisch beispielsweise durch Filtration, Fällung oder Zentrifugation getrennt, mehrmals gewaschen, um Verunreinigungen zu entfernen und für den Druckprozess vorbereitet. Die Nanopartikel haben auf ihrer Oberfläche die monomolekulare Schicht aus stabilisierenden organischen oder anorganischen Molekülen, die die Aggregation in den kolloidalen Tinten für das Tintenstrahldrucken oder die Rekristallisation und die elektrische Leitfähigkeit in den trockenen Pulvern für das Laserdrucken verhindern.

Für das Tintenstrahldrucken müssen die Nanopartikel in eine stabile wässrige oder organische Lösung gebracht werden, um eine kolloidale Lösung oder Suspension zu formen. Zu diesem Zweck wählt man ein geeignetes Lösungsmittel und/oder passende Oberflächenveränderungen der Nanopartikel, um eine gute Löslichkeit zu erreichen. Die monomolekulare Schicht aus stabilisierenden Molekülen verhindert, dass sich die Nanopartikel in den kolloidalen Tinten aggregieren.

Für das Laserdrucken werden die Nanopartikel getrocknet und das Pulver wird zu der passenden Maschenweite homogenisiert. Die mechanischen Eigenschaften eines Pulvers aus Nanopartikeln können durch die Oberflächenbeschaffenheit der Nanopartikel vor dem Trocknen eingestellt werden. Die monomolekulare Schicht aus stabilisierenden Molekülen verhindert die Rekristallisation der Nanopartikel bei Raumtemperatur und die elektrische Leitfähigkeit derart, dass die Nanopartikel nicht an der Fotorezeptortrommel elektrostatisch aufgeladen werden.

Das Tintenstrahldrucken kann erfolgen, indem man entweder Standardtintenstrahldrucker, Plotter oder eigens entworfene Instrumente verwendet, die es erlauben, die für den Tintenstrahldruck von verschiedenen kolloidalen Lösungen passenden Druckerparameter (Volumen der Mikrotropfen, Einspritzungsgeschwindigkeit etc.) getrennt voneinander einzustellen. Das Tintenstrahldrucken kann auf steifen (Glas, Polymere, Metalle) oder flexiblen (Polymere, Metalle) Substraten erfolgen. Bei Bedarf kann die Oberfläche des Substrates für eine bessere Adhäsion der Nanopartikel und Polymere angepasst werden; ein anderer Weg ist, die Benetzungseigenschaften der kolloidalen Lösung aus Nanopartikeln auf das Substrat einzustellen. Das Substrat enthält möglicherweise strukturierte Schichten oder Elemente, die vor dem Drucken bereits vorhanden sind. Die strukturierten und gedruckten Schichten können einen thermoelektrischen Generator ausbilden.

Nach kompletter Verdampfung des Lösungsmittels und der Bildung der festen thermoelektrischen Schichten oder der Elemente aus den oben beschriebenen Nanopartikeln folgt ein thermisches Sintern und Fixieren durch eine geeignete Wärmebehandlung: thermisches Rollen, IR- oder UHF Heizung, Laser-Behandlung oder eine Kombination davon.

Die monomolekulare Schicht von stabilisierenden Molekülen wird durch das Sintern thermisch von der Oberfläche der Nanopartikel entfernt, um die Rekristallisation der Nanopartikel zu ermöglichen und die elektrische Leitfähigkeit zwischen den benachbarten Nanopartikeln und über die gesamte gesinterte Schicht zu erzielen. Bei Bedarf können zusätzliche Elemente oder Schichten (elektrische Komponenten, schützende Abdeckung, etc.) auf den thermoelektrischen Filmen oder den Elementen durch ein ähnliches Tintenstrahlverfahren oder eine andere Methode gebildet werden.

Um die Wärmeleitfähigkeit von den thermoelektrischen porösen Filmen zu verringern, werden feste oder hohle Nanokugeln aus Titania, Tonerde, Glas oder Quarz, in die kolloidale Lösungen für das Tintenstrahldrucken mit eingebracht, sodass nach der Wärmebehandlung diese Nanokugeln Bereiche mit niedriger Wärmeleitfähigkeit innerhalb der thermoelektrischen Matrix bilden.

Das Laserjet-Drucken kann erfolgen, indem man entweder Standard-Laserdrucker oder besonders entworfene Instrumente verwendet, die es ermöglichen, die erforderlichen unterschiedlichen Druckerparametern für das Laserdrucken separat einzustellen (statische Aufladung, Laserstrahlintensität, Druckgeschwindigkeit etc.). Die monomolekulare Schicht von stabilisierenden Molekülen auf der Oberfläche der Nanopartikel macht die niedrige elektrische Leitfähigkeit und die einfache elektrostatische Aufladung der Partikeln an der Fotorezeptortrommel möglich. Das Laserdrucken kann auf steifen (Glas, Polymere, Metalle) oder flexiblen (Polymere, Metalle) Substraten durchgeführt werden. Bei Bedarf kann die Oberfläche des Substrates für eine bessere Adhäsion der Nanopartikel verändert werden. Das Substrat enthält möglicherweise strukturierte Schichten oder Elemente, die notwendig sind, um funktionierende elektrische oder elektronische Bauelemente zu erhalten. Nach dem Drucken des Pulvers aus den oben beschriebenen Nanopartikeln auf das Substrat folgt ein thermischer Sinterschritt: thermisches Rollen, IR- oder UHF Heizung oder eine Kombination davon. Die monomolekulare Schicht von stabilisierenden Molekülen wird thermisch von der Oberfläche der Nanopartikel entfernt, um die Rekristallisation der Nanopartikel zu ermöglichen und die elektrische Leitfähigkeit zwischen den benachbarten Nanopartikeln und über die gesamte gesinterte Schicht zu erzielen. Bei Bedarf können zusätzliche thermoelektrische Elemente oder Schichten (elektrische Komponenten, schützende Abdeckung, etc.) auf den Schichten oder den Elementen gebildet werden, die mit ähnlichen Laserjet-Verfahren oder anderen Verfahren gemacht werden.

Um die thermische Leitfähigkeit der gesinterten Schichten noch weiter zu verkleinern, können die Nanopartikel aus den thermoelektrischen Materialien als drahtförmige oder "vier-Bein"-förmige Partikel in den kolloidalen Tinten für das Tintenstrahldrucken oder Pulvern für das Laserjet Drucken verwendet werden. Thermisches Sintern mit an das Material angepasster Temperatur und Dauer sorgt dann dafür, dass die gesinterten Schichten aus thermoelektrischen "Nano-Wires" oder verzweigten Nanopartikeln nanoporös werden, was die thermische Leitfähigkeit verkleinert.
10. PbTe/PbSe tetrapod-ähnliche (oder Nanosterne) Nanopartikel wurden synthetisiert und gesintert, um nanoporöse thermoelektrische Schichten herzustellen *(Thermoelectric Properties of Lead Chalcogenide Core_Shell Nanostructures. Marcus Scheele, Niels Oeschler, Igor Veremchuk, Sven-Ole Peters, Alexander Littig, Andreas Kornowski, Christian Klinke, and Horst Weller. ACS Nano DOI: 10.1021*/*nn2017183).*

Schichten, die mit den beschriebenen Prozessen hergestellt wurden, können Verunreinigungen wie Kohlenstoff oder Sauerstoff beinhalten, was aber keinen Einfluss auf die Leistungsfähigkeit der Bauteile hat.

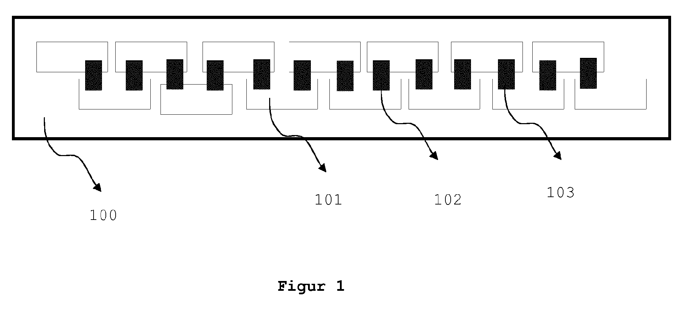

Nachfolgend wird die Erfindung anhand mehrerer, nicht einschränkender Ausführungsbeispiele näher erläutert:
**Beispiel 1** offenbart die Bildung von thermoelektrischen Filmen aus n-typ Bi₄₀Te₅₄Se₆ Nanopartikeln durch Tintenstrahldrucken unter Verwendung einer wässrigen kolloidalen Lösung von Bi₄₀Te₅₄Se₆ Nanopartikeln. Bi₄₀Te₅₄Se₆ Nanopartikel von ca. 50-100 Nanometer Durchmesser und unregelmäßiger Form wurden zuerst auf dem kolloidalen Weg synthetisiert. 50 mmol des Wismutnitrats wurden mit 10 ml destilliertem Wasser kurz gemischt und 0,1 mmol von EDTA (vierwertige Säure des Ethylendiamins) sofort hinzugefügt, um einen pH-Wert der Lösung von ca. 1,6 zu erzielen. Dann wurde eine 6 M Lösung von NaOH hinzugefügt, um den pH-Wert der Mischung von 11,5 zu erzielen. Die Mischung wurde 4-6 Stunden gerührt, um schließlich eine klare und transparente Lösung zu erreichen. Parallel wurden 0,1 Mol elementares Tellur und 0,02 Mol elementares Selen in Pulverform mit wässeriger Lösung des Natriumborhydrids gemischt, mit Argon gespült, auf 95°C erhitzt und durch kräftiges Rühren das Tellur komplett aufgelöst. Die Lösung des Wismutsalzes wurde schnell zu einer Lösung des Tellurs unter kräftigem Rühren gegeben und das Reaktionsgemisch für zusätzlich 30-40 Stunden im Kreis geführt. Der schwarze Niederschlag wurde vom Reaktionsgemisch durch Zentrifugierung getrennt, mehrmals mit destilliertem Wasser gewaschen und getrocknet.
   Ungefähr 100 mg der trockenen Bi₄₀Te₅₄Se₆ Nanopartikel wurden mit 2 ml Methanol, Ethanol, Isopropanol oder einem anderen passenden Lösungsmittel gemischt und in einem versiegelten Gefäß mittels Ultraschall homogenisiert. Danach wurden 0,1 ml Dodecanthiol der Mischung von Nanopartikeln und organischen Lösungsmittel hinzugefügt, um auf ihrer Oberfläche die monomolekulare Schicht von stabilisierenden Molekülen zu bilden. Die kolloidale Lösung von Bi₄₀Te₅₄Se₆ wurde durch einen 0,45-Mikrometer-Membranfilter geleitet, um die aggregierten Nanopartikel zu entfernen. Dann wurde die kolloidale Lösung in die Tintenstrahlpatrone geladen und die thermoelektrischen Elemente wurden auf Polyimidfilm ausgedruckt und bei Zimmertemperatur unter einer Belüftungshaube getrocknet. Die getrockneten Schichten oder die Elemente, die Bi₄₀Te₅₄Se₆ Nanopartikel enthalten, wurden durch Rollen bei 200-250° C für 1-60 Minuten thermisch gesintert. Die monomolekulare Schicht von Dodecanethiol wird thermisch von der Oberfläche der Nanopartikel entfernt, um das Sintern und die Rekristallisation der Partikel zu ermöglichen und die elektrische Leitfähigkeit zwischen den benachbarten Nanopartikeln und über die gesamte gesinterte Schicht zu erzielen.
   P-typ thermoelektrische Schichten oder Elemente aus Bi₁₀Sb₃₀Te₆₀ Nanopartikeln, die durch einen ähnlichen kolloidalen Weg wie Bi₄₀Te₅₄Se₆ Nanopartikel synthetisiert wurden, wurden hergestellt. 10 mmol Wismutnitrat wurden mit 30 mmol Antimons (iii) Chlorid kurz mit 10 ml destilliertem Wasser gemischt und 0,1 mmol von EDTA (vierwertige Säure des Ethylendiamins) sofort hinzugefügt, um den pH-Wert der Lösung auf 1,6 zu bringen. Dann wurde eine 6 M Lösung NaOH hinzugefügt, um einen pH-Wert von 11,5 zu erreichen. Die Mischung wurde 4-6 Stunden gerührt, um eine klare und transparente Lösung zu erreichen. Parallel wurde 0,1 Mol elementares Tellur in der Pulverform mit wässeriger Lösung des Natriumborhydrids gemischt, mit Argon gespült und auf 95° C unter kräftigem Rühren bis zum kompletten Auflösen des Te erhitzt. Die Lösung von Wismut- und Antimonsalzen wurde schnell in die Lösung des Tellurs eingespritzt und 30-40 Stunden im Rückfluss gerührt. Der schwarze Niederschlag wurde vom Reaktionsgemisch durch Zentrifugierung getrennt, mehrmals mit destilliertem Wasser gewaschen und anschließend getrocknet.
   Ungefähr 100 mg der trockenen Bi₁₀Sb₃₀Te₆₀ Nanopartikel wurden mit 2 ml Methanol, Ethanol, Isopropanol oder einem anderen passenden Lösungsmittel gemischt und in einem versiegelten Gefäß mittels Ultraschall homogenisiert. Danach wurden 0,1 ml Dodecanthiol der Mischung von Nanopartikeln und organischen Lösungsmittel hinzugefügt, um auf ihrer Oberfläche die monomolekulare Schicht von stabilisierenden Molekülen zu bilden. Die kolloidale Lösung von Bi₁₀Sb₃₀Te₆₀ wurde durch einen 0,45-Mikrometer-Membranfilter geleitet, um die aggregierten Nanopartikel zu entfernen. Dann wurde die kolloidale Lösung in die Tintenstrahlpatrone geladen und die thermoelektrischen Elemente wurden auf Polyimidfilm ausgedruckt und bei Zimmertemperatur unter einer Belüftungshaube getrocknet. Die getrockneten Schichten oder die Elemente, die Bi₁₀Sb₃₀Te₆₀ Nanopartikel enthalten, wurden durch Rollen bei 200-250 °C für 1-60 Minuten thermisch gesintert. Die monomolekulare Schicht von Dodecanethiol wird thermisch von der Oberfläche der Nanopartikel entfernt, um das Sintern und die Rekristallisation der Partikel zu ermöglichen und die elektrische Leitfähigkeit zwischen den benachbarten Partikeln und über die gesamte gesinterte Schicht zu erzielen.
**Beispiel 2** demonstriert die Bildung von thermoelektrischen Schichten aus n-typ Bi₄₀Te₅₄Se₆ Nanopartikeln mittels Laserjet-Drucken unter Verwendung der wässrigen kolloidalen Lösung von Bi₄₀Te₅₄Se₆ Nanopartikeln. Bi₄₀Te₅₄Se₆ Nanopartikel von ca. 50-100 Nanometer Durchmesser und unregelmäßiger Form wurden zuerst auf dem kolloidalen Weg synthetisiert. 50 mmol des Wismutnitrats wurden mit 10 ml destilliertem Wasser kurz gemischt und 0,1 mmol von EDTA (vierwertige Säure des Ethylendiamins) sofort hinzugefügt, um einen pH-Wert der Lösung von ca. 1,6 zu erzielen. Dann wurde eine 6 M Lösung von NaOH hinzugefügt, um den pH-Wert der Mischung von 11,5 zu erzielen. Die Mischung wurde 4-6 Stunden gerührt, um schließlich eine klare und transparente Lösung zu erreichen. Parallel wurden 0,1 Mol elementares Tellur und 0,02 Mol elementares Selen in Pulverform mit wässeriger Lösung des Natriumborhydrids gemischt, mit Argon gespült, auf 95°C erhitzt und durch kräftiges Rühren das Tellur komplett aufgelöst. Die Lösung des Wismutsalzes wurde schnell zu einer Lösung des Tellurs unter kräftigem Rühren gegeben und das Reaktionsgemisch für zusätzlich 30-40 Stunden im Kreis geführt. Der schwarze Niederschlag wurde vom Reaktionsgemisch durch Zentrifugierung getrennt, mehrmals mit destilliertem Wasser gewaschen und getrocknet.
   Ungefähr 10 g der trockenen Bi₄₀Te₅₄Se₆ Nanopartikel wurden mit 200 ml Methanol, Ethanol, Isopropanol oder einem anderen passenden Lösungsmittel gemischt und in einem versiegelten Gefäß mittels Ultraschall homogenisiert. Danach wurden 0,1 ml Dodecanthiol der Mischung von Nanopartikel und organischen Lösungsmittel hinzugefügt, um auf ihrer Oberfläche die monomolekulare Schicht von stabilisierenden Molekülen zu bilden. Die kolloidale Lösung von Bi₁₀Sb₃₀Te₆₀ wurde durch einen 0,45-Mikrometer-Membranfilter geleitet, um die aggregierten Nanopartikel zu entfernen. Das Lösungsmittel wurde aus der Mischung verdunstet und zu einem Pulver aus den Bi₄₀Te₅₄Se₆ Nanopartikel getrocknet, die zuvor mit der monomolekularen Schicht aus Dodecanethiol bedeckt wurden. Das Pulver aus den Nanopartikeln wurde in eine Tonerpatrone und darin in den Laserdrucker geladen und ausgedruckt. Das Druckverfahren wird durch die elektrostatische Aufladung von den Bi₄₀Te₅₄Se₆ Nanopartikeln ermöglicht, welche auf ihrer Oberfläche die monomolekulare Schicht von Dodecanethiol haben, das die elektrische Leitfähigkeit zwischen den benachbarten Partikeln im Pulver verhindert. Die getrockneten Schichten oder die Elemente, die die Nanopartikel enthalten, wurden thermisch unter Verwendung des thermischen Rollens bei 200-250° C für 1-3 Min. gesintert. Die monomolekulare Schicht aus Dodecanethiol wird durch druckloses Sintern thermisch von der Oberfläche der Nanopartikel entfernt, um die Rekristallisation der Nanopartikel zu ermöglichen und die elektrische Leitfähigkeit zwischen den benachbarten Nanopartikel und der gesamten Schicht zu gewährleisten.
   P-typ thermoelektrische Schichten oder Elemente aus Bi₁₀Sb₃₀Te₆₀ Nanopartikeln, die durch einen ähnlichen kolloidalen Weg wie Bi₄₀Te₅₄Se₆ Nanopartikel synthetisiert wurden, wurden hergestellt. 10 mmol Wismutnitrat wurden mit 30 mmol Antimons (iii) Chlorid wurden kurz mit 10 ml destilliertem Wasser gemischt und 0,1 mmol von EDTA (vierwertige Säure des Ethylendiamins) sofort hinzugefügt, um den pH-Wert der Lösung auf 1,6 zu bringen. Dann wurde eine 6 M Lösung NaOH hinzugefügt, um einen pH-Wert von 11,5 zu erreichen. Die Mischung wurde 4-6 Stunden gerührt, um eine klare und transparente Lösung zu erreichen. Parallel wurde 0,1 Mol elementares Tellur in Pulverform mit wässeriger Lösung des Natriumborhydrids gemischt, mit Argon gespült und auf 95° C unter kräftigem Rühren bis zum kompletten Auflösen des Te erhitzt. Die Lösung von Wismut- und Antimonsalzen wurde schnell in die Lösung des Tellurs eingespritzt und weiter 30-40 Stunden im Rückfluss gerührt. Der schwarze Niederschlag wurde vom Reaktionsgemisch durch Zentrifugierung getrennt, mehrmals mit destilliertem Wasser gewaschen und anschließend getrocknet.
   Ungefähr 10 g der trockenen Bi₁₀Sb₃₀Te₆₀ Nanopartikel wurden mit 200 ml Methanol, Ethanol, Isopropanol oder einem anderen passenden Lösungsmittel gemischt und in einem versiegelten Gefäß mittels Ultraschall homogenisiert. Danach wurden 0,1 ml Dodecanthiol der Mischung von Nanopartikeln und organischen Lösungsmittel hinzugefügt, um auf ihrer Oberfläche die monomolekulare Schicht von stabilisierenden Molekülen zu bilden. Die kolloidale Lösung von Bi₁₀Sb₃₀Te₆₀ wurde durch einen 0,45-Mikrometer-Membranfilter geleitet, um die aggregierten Nanopartikel zu entfernen. Das Lösungsmittel wurde aus der Mischung verdunstet und zu einem Pulver aus den Bi₁₀Sb₃₀Te₆₀ Nanopartikel getrocknet, die zuvor mit der monomolekularen Schicht aus Dodecanethiol bedeckt wurden. Das Pulver aus den Nanopartikeln wurde in eine Tonerpatrone und darin in den Laserdrucker geladen und ausgedruckt. Das Druckverfahren wird durch die elektrostatische Aufladung von den Bi₁₀Sb₃₀Te₆₀ Nanopartikel ermöglicht, welche auf ihrer Oberfläche die monomolekulare Schicht von Dodecanethiol haben, das die elektrische Leitfähigkeit zwischen den benachbarten Partikel im Pulver verhindert. Die getrocknete Schicht oder die Elemente, die die Nanopartikel enthalten, wurden thermisch unter Verwendung des thermischen Rollens bei 200-250 °C für 1-3 Min. gesintert. Die monomolekulare Schicht aus Dodecanethiol wird thermisch von der Oberfläche der Nanopartikel entfernt, um die Rekristallisation der Partikel zu ermöglichen und die elektrische Leitfähigkeit zwischen den benachbarten Partikeln und der gesamten Schicht zu gewährleisten.
**Beispiel 3** betrifft das Tintenstrahldrucken von Bauteilen mit 2 Anschlüssen. Der Herstellungsweg wird anhand von Figur 1 beschrieben:
   1. p-dotierte thermoelektrische Materialien (102) und n-dotierte - thermoelektrische Materialien (103) werden durch Tintenstrahldrucken auf ein flexibles oder steifes Substrat (100) mit Kupferkontakten (101) gedruckt. Diese kupfernen Flächen können mit einer Ni-Schicht beschichtet werden (Fig. 1). Das Substratmaterial kann jedes Plastik, Silikon, Glas oder keramische Material mit niedriger Wärmeleitfähigkeit, wie Kevlar, Kapton, verschiedene Leiterplatten-Materialien wie EP2, 85N, 35N oder Verbundwerkstoffe sein. Die kupfernen Flächen können aus Kupferlegierungen bestehen, wobei reinem Kupfer der Vorzug zu geben ist. Die Tinte enthält BiTe-Nanopartikel, die optional mit Se, Sb oder anderen Materialien dotiert sind; alternativ enthält die Tinte SiGe-Nanopartikel die optional dotiert sind mit P, As, B, etc.
   2.Nach dem Druck werden die p- und n-dotierten thermoelektrischen Materialien gesintert. Das Sintern erfolgt mittels einer Heizung oder Mikrowellenstrahlung.

   Das Bauteil funktioniert folgendermaßen. Die obere Reihe der Kupferkontakten (101) wird an eine Wärmequelle angeschlossen und die untere Reihe von Kupferkontakten wird an einen Kühlkörper angeschlossen. Die p- und n-dotierten thermoelektrischen Materialien (102/103) werden in einer Reihe durch die Kupferkontakte (101) verbunden. Ein Temperaturgradient über die thermoelektrischen Materialien (102/103) erzeugt eine elektrische Spannung, die sich aufgrund der Reihenschaltung addiert.
**Beispiel 4** offenbart die Bildung von thermoelektrischen Filmen aus n-typ Bi₄₀Te₅₄Se₆ Nanopartikeln mit Hohlräumen durch Tintenstrahldrucken unter Verwendung der wässrigen kolloidalen Lösung von Bi₄₀Te₅₄Se₆ Nanopartikeln. Bi₄₀Te₅₄Se₆ Nanopartikel von ca. 50-100 Nanometer Durchmesser und unregelmäßiger Form wurden zuerst auf dem kolloidalen Weg synthetisiert wie in Beispiel 1. Ungefähr 100 mg der trockenen Bi₄₀Te₅₄Se₆ Nanopartikel wurden mit 2 ml Methanols, Ethanol, Isopropanol oder einem anderen passenden Lösungsmittel gemischt und in einem versiegelten Gefäß mittels Ultraschall homogenisiert. Danach wurden 0,1 ml Dodecanthiol der Mischung von Nanopartikeln und organischem Lösungsmittel hinzugefügt, um auf ihrer Oberfläche die monomolekulare Schicht von stabilisierenden Molekülen zu bilden. Die kolloidale Lösung von Bi₄₀Te₅₄Se₆ wurde durch einen 0,45-Mikrometer-Membranfilter geleitet, um die aggregierten Nanopartikel zu entfernen. Zu dieser Lösung wurden ca. 10 mg SiO₂ Nanokugeln mit ca. 20 Nanometer Durchmesser (Aldrich, 637238) hinzugefügt und die Lösung wieder für 10 Minuten mit Ultraschall homogenisiert. Dann wurde die kolloidale Lösung in die Tintenstrahlpatrone geladen und die thermoelektrischen Elemente wurden auf Polyimidfilm ausgedruckt und bei Zimmertemperatur unter einer Belüftungshaube getrocknet. Die getrockneten Schichten oder die Elemente, die Bi₄₀Te₅₄Se₆ Nanopartikel enthalten, wurden durch Rollen bei 200-250° C für 1-60 Minuten thermisch gesintert. Die monomolekulare Schicht von Dodecanethiol wird durch Sintern von der Oberfläche der Nanopartikel entfernt, um die Rekristallisation der Nanopartikel zu ermöglichen und die elektrische Leitfähigkeit zwischen den benachbarten Nanopartikeln und über die gesamte gesinterte Schicht zu erzielen. Die SiO₂ Nanokugeln bleiben ungesintert und schaffen Hohlräume mit niedriger Wärmeleitfähigkeit in der gesinterten Schicht.
**Beispiel 5** demonstriert die Synthese von Bi₄₀Te₅₄Se₆ Nanowires und Tetrapods. 1 mmol Wismutethylhexanoat wurde in 6 ml Oktadezen aufgelöst, dazu dann 200 mg Hexadecylphosphonic Säure hinzufügt. Das Reaktionsgemisch wurde auf 160 °C erhitzt und im Vakuum bei 10 mbar für 30 Min. entgast. Separat wurden 1 mmol elementares Te und 0,1 mmol Selen in das Reaktionsrohr geladen, das mit 2 ml Trioctylphosphine gefüllt wurde (TOP). Die Mischung wurde mit Argon gewaschen und auf 250°C erhitzt, bis eine klare orangegelbe Lösung erschien. Die Lösung von Se und Te in TOP wurde in die die Lösung des Bi-Salzes im Oktadezen bei 160 °C eingespritzt und die Mischung zusätzlich für 5-30 Min. verrührt. Dieses Verfahren produziert Bi₄₀Te₅₄Se₆ Nanowires oder Nanorods mit unterschiedlichen Längen und Durchmesser. Das Durchmesser-zu-Länge Verhältnis hängt größtenteils von der Konzentration der Hexadecylphosphonic Säure ab und verringert sich bei Zunahme der Konzentration der phosphonischen Säure. Um die Tetrapod ähnlichen Bi₄₀Te₅₄Se₆ Nanopartikel zu erhalten wurde das Mehrfach-Einspritz-Verfahren verwendet. Zuerst wurden nur 20% der Se/Te Lösung in TOP bei 160 °C eingespritzt und das Reaktionsgemisch für 5 Minuten gerührt, um die Bildung von kugelförmigen Keimen zu erzielen. Der Rest der Se/Te Lösung wurde tropfenweise bei 160° C während eines Zeitraums von 5-10 Min. eingespritzt. Nach dem Ende des Wachstums wurde das Reaktionsgemisch bis 70° C abgekühlt, die Nanopartikel mit Isopropanol ausgefällt, mehrmals mit Isopropanol gewaschen und anschließend getrocknet. Die trockenen hydrophoben Nanopartikel können in Toluol gelöst werden und ergeben somit Tinten, oder können als Pulver für Laserdrucken benutzt werden.
**Beispiel 6** zeigt, wie die elektrostatischen Aufladungseigenschaften von hydrophoben Bi₄₀Te₅₄Se₆ Nanopartikeln geändert werden können, um sie für Laserdruckverfahren zu verwenden. Die hydrophoben Nanopartikel (ca. 100 mg), die mittels der in Beispiel 5 beschriebenen Methode hergestellt wurden, wurden in 50 ml Toluol gelöst, zu welchem 5 mg von einem von verschiedenen aliphatischen Thiolalkoholen (Butanethiol, Hexanethiol, Dekanethiol, Dodekanethiol, Hexadekanethiol, Octadekanethiol) hinzugefügt wurden. Das Reaktionsgemisch wurde bei Zimmertemperatur für 2 h gerührt, das Toluol durch sanfte Verdampfung entfernt und die feste Phase, die Bi₄₀Te₅₄Se₆ Nanopartikel, mit der monomolekularen Oberflächenschicht des entsprechenden Thiolalkohols mehrmals mit Isopropanol gewaschen, um den Überfluss von organischen Produkten zu entfernen. Dann wurde die feste Phase zum Pulver getrocknet und für das Laserdrucken verwendet. Die erhöhte Länge des aliphatischen Thiolalkohols auf der Oberfläche der Nanopartikel ergibt die größere elektrostatische Aufladung wegen der verringerten Leitfähigkeit zwischen den Partikeln.

Zusammenfassend besteht die Erfindung darin, dass die Nanopartikel so synthetisiert und bereitgestellt werden, dass die Druckprozesse (Tintenstrahl- und Laserdruckprozesse) optimal durchgeführt werden können, jedoch ein anschließendes druckloses Sintern möglich ist. Das drucklose Sintern führt zu dichten Schichten, wodurch die mechanischen und thermoelektrischen Eigenschaften des Materials die Werte erreichen, die mit anderen Verfahren (insbesondere Schmelz-, Sinterverfahren mit Druck) erhalten werden. Die bereitgestellten Nanopartikel werden derart bei der Synthese geformt, dass die Oberfläche groß im Vergleich zum Volumen ist und dass sich die Partikel aufgrund ihrer Form rein mechanisch verzahnen. Diese Eigenschaften der bereitgestellten Nanopartikel bewirken, dass der Sinterprozess auch ohne Ausübung von Druck zu einer guten Verbindung aller Nanopartikel führt. Damit die Nanopartikel während der Druckprozesse nicht miteinander reagieren, werden die Partikel mit einer molekularen Schicht (Monolage) überzogen, die die Aggregation der Partikel verhindert und somit eine homogene Verteilung der Teilchen in der Tinte (kolloidale Lösung) bewirkt bzw. die Pulver für den Laserdruck elektrisch nicht leitfähig macht, so dass sie elektrostatisch aufgeladen werden können, um als Toner zu funktionieren. Diese molekulare Schicht wird nach dem Druckprozess durch die Sinterbehandlung entfernt, durch den die Partikel eine sehr reaktive Oberfläche erhalten. Das drucklose Sintern führt zu guten Verbindungen zwischen den Nanopartikeln untereinander.

## Patentansprüche

1. Verfahren zum Abscheiden von thermoelektrischem Material auf einem Substrat umfassend die Schritte:
- Bereitstellen von Nanopartikeln aus thermoelektrischem Material,
- Einbringen der Nanopartikel in ein Kolloidsystem mit einem flüssigen Medium,
- Bilden einer molekularen Schicht an der Oberfläche der Nanopartikel in dem Kolloidsystem, um eine Aggregation der Nanopartikel zu verhindern,
- Anschließendes Aufbringen des Kolloidsystems auf dem Substrat im Wege eines Tintenstrahldruckprozesses sowie
- Druckloses Sintern der aufgebrachten Nanopartikel derart, dass die molekulare Schicht durch das Sintern von den Nanopartikeln entfernt und eine elektrische Leitfähigkeit zwischen den Nanopartikeln hergestellt wird.

2. Verfahren nach Anspruch 1, **dadurch gekennzeichnet, dass** das Kolloidsystem vor dem Aufbringen des Kolloidsystems gefiltert wird, um aggregierte Nanopartikel zu entfernen.

3. Verfahren nach Anspruch 1 oder 2, **dadurch gekennzeichnet, dass** das aufgebrachte Kolloidsystem vor dem drucklosen Sintern getrocknet wird.

4. Verfahren zum Abscheiden von thermoelektrischem Material auf einem Substrat umfassend die Schritte:
- Bereitstellen von getrockneten Nanopartikeln aus thermoelektrischem Material,
- Einbringen der getrockneten Nanopartikel in ein Kolloidsystem mit einem flüssigen Medium,
- Bilden einer molekularen Schicht an der Oberfläche der Nanopartikel in dem Kolloidsystem, um eine Aggregation der Nanopartikel zu verhindern,
- Entfernen des flüssigen Mediums des Kolloidsystems, so dass die mit der molekularen Schicht versehenen Nanopartikel als Pulver vorliegen,
- Anschließendes Aufbringen der als Pulver vorliegenden Nanopartikel auf dem Substrat im Wege eines Laserdruckprozesses sowie
- Druckloses Sintern der aufgebrachten Nanopartikel derart, dass die molekulare Schicht durch das Sintern von den Nanopartikeln entfernt und eine elektrische Leitfähigkeit zwischen den Nanopartikeln hergestellt wird.

5. Verfahren nach Anspruch 4, **dadurch gekennzeichnet, dass** das Kolloidsystem vor dem Entfernen des flüssigen Medium gefiltert wird, um aggregierte Nanopartikel zu entfernen.

6. Verfahren nach einem der Ansprüche 1 bis 5, **dadurch gekennzeichnet, dass** die Nanopartikel aus thermoelektrischem Material durch kolloidale chemische Synthese bereitgestellt werden.

7. Verfahren nach einem der Ansprüche 1 bis 6, **dadurch gekennzeichnet, dass** die bereitgestellten Nanopartikel derart geformt sind, dass eine Verzahnung zwischen den Nanopartikeln erreicht wird.

8. Verfahren nach einem der Ansprüche 1 bis 7, **dadurch gekennzeichnet, dass** die bereitgestellten Nanopartikel unregelmäßig geformt sind.

9. Verfahren nach einem der Ansprüche 1 bis 8, **dadurch gekennzeichnet, dass** die bereitgestellten Nanopartikel eine maximale Erstreckung von 1 - 1000 Nanometer aufweisen.

10. Verfahren nach einem der Ansprüche 1 bis 9, **dadurch gekennzeichnet, dass** die bereitgestellten Nanopartikel eine kugelförmige, kubische, stangenförmige, drahtartige Form oder die Form einer Tatrapode aufweisen.

11. Verfahren nach einem der Ansprüche 1 bis 10, **dadurch gekennzeichnet, dass** das Kolloidsystem vor der Bildung der molekularen Schicht an der Oberfläche der Nanopartikel homogenisiert wird.

12. Verfahren nach Anspruch 11, **dadurch gekennzeichnet, dass** die Homogenisierung mittels Ultraschall erfolgt.

13. Verfahren nach einem der Ansprüche 1 bis 12, **dadurch gekennzeichnet, dass** dem Kolloidsystem poröse und /oder hohle Nanoteilchen beigemengt werden.

14. Verfahren nach Anspruch 13, **dadurch gekennzeichnet, dass** die Nanoteilchen aus SiO₂, TiO₂, Al₂O₃, Glas oder Quarz bestehen.

## Claims

1. A method for the deposition of thermoelectric material on a substrate comprising the steps:
- providing nanoparticles made of thermoelectric material,
- introducing the nanoparticles into a colloidal system comprising a liquid medium,
- forming a molecular layer on the surface of the nanoparticles in the colloidal system to prevent any aggregation of the nanoparticles,
- subsequently applying the colloidal system to the substrate by an inkjet printing process and
- pressureless sintering of the nanoparticles applied to the substrate in such a manner that the molecular layer is removed from the nanoparticles by the sintering and an electrical conductivity is established between the nanoparticles.

2. The method according to claim 1, **characterized in that** the colloidal system is filtered before applying the colloidal system in order to remove aggregated nanoparticles.

3. The method according to claim 1 or 2, **characterized in that** the applied colloidal system is dried before the pressureless sintering.

4. A method for the deposition of thermoelectric material on a substrate comprising the steps:
- providing dried nanoparticles made of thermoelectric material,
- introducing the dried nanoparticles into a colloidal system comprising a liquid medium,
- forming a molecular layer on the surface of the nanoparticles in the colloidal system to prevent any aggregation of the nanoparticles,
- removing the liquid medium of the colloidal system, so that the nanoparticles provided with the molecular layer are present in the form of a powder,
- subsequently applying the nanoparticles present as a powder to the substrate by a laser printing process; and
- pressureless sintering of the applied nanoparticles in such a manner that the molecular layer is removed from the nanoparticles by the sintering and an electrical conductivity is established between the nanoparticles.

5. The method according to claim 4, **characterized in that** the colloidal system is filtered before removal of the liquid medium in order to remove aggregated nanoparticles.

6. The method according to any one of claims 1 to 5, **characterized in that** the nanoparticles of thermoelectric material are provided using colloidal chemical synthesis.

7. The method according to any one of claims 1 to 6, **characterized in that** the provided nanoparticles are shaped such that the nanoparticles interlock with each other.

8. The method according to any one of claims 1 to 7, **characterized in that** the provided nanoparticles are of irregular shape.

9. The method according to any one of claims 1 to 8, **characterized in that** the provided nanoparticles have a maximum dimension of 1-1,000 nm.

10. The method according to any one of claims 1 to 9, **characterized in that** the provided nanoparticles are spherical, cubic, rod-shaped, or wire-shaped, or tetrapod-shaped.

11. The method according to any one of claims 1 to 10, **characterized in that** the colloidal system is homogenized before the step of forming the molecular layer on the surface of the nanoparticles.

12. The method according to claim 11, **characterized in that** the homogenizing is carried out using ultrasound.

13. The method according to any one of claims 1 to 12, **characterized in that** porous and/or hollow nanoparticles are mixed into the colloidal system.

14. The method according to claim 13, **characterized in that** the nanoparticles consist of SiO₂, TiO₂, Al₂O₃, glass, or quartz.

## Revendications

1. Procédé destiné à déposer une matière thermoélectrique sur un substrat, comprenant les étapes :
- mise à disposition de nanoparticules d'une matière thermoélectrique,
- introduction des nanoparticules dans un système colloïdal avec un agent liquide,
- formation d'une couche moléculaire sur la surface des nanoparticules dans le système colloïdal, pour empêcher une agglomération des nanoparticules,
- application par la suite du système colloïdal sur le substrat, par la voie du processus d'impression au jet d'encre, ainsi que
- frittage sans pression des nanoparticules appliquées, de telle sorte que par le frittage, la couche moléculaire soit retirée des nanoparticules et qu'une conductibilité électrique soit établie entre les nanoparticules.

2. Procédé selon la revendication 1, **caractérisé en ce qu'**avant d'appliquer le système colloïdal, on filtre le système colloïdal pour éliminer des nanoparticules agglomérées.

3. Procédé selon la revendication 1 ou 2, **caractérisé en ce qu'**avant le frittage sans pression, on sèche le système colloïdal appliqué.

4. Procédé destiné à déposer une matière thermoélectrique sur un substrat, comprenant les étampes :
- mise à disposition de nanoparticules séchées en une matière thermoélectrique,
- introduction des nanoparticules séchées dans un système colloïdal avec un agent liquide,
- formation d'une couche moléculaire sur la surface des nanoparticules dans le système colloïdal, pour empêcher une agglomération des nanoparticules,
- retrait de l'agent liquide du système colloïdal, de sorte que les nanoparticules munies de la couche moléculaire se présentent sous la forme de poudre,
- application par la suite des nanoparticules présentes sous forme de poudre sur le substrat, par la voie d'un processus d'impression laser, ainsi que
- frittage sans pression des nanoparticules appliquées, de telle sorte que par le frittage, la couche moléculaire soit retirée des nanoparticules et qu'une conductibilité électrique soit établie entre les nanoparticules.

5. Procédé selon la revendication 4, **caractérisé en ce qu'**avant de retirer l'agent liquide, on filtre le système colloïdal pour éliminer des nanoparticules agglomérées.

6. Procédé selon l'une quelconque des revendications 1 à 5, **caractérisé en ce qu'**on met à disposition les nanoparticules d'une matière thermoélectrique par synthèse chimique colloïdale.

7. Procédé selon l'une quelconque des revendications 1 à 6, **caractérisé en ce que** les nanoparticules mises à disposition sont façonnées de sorte qu'une denture soit obtenue entre les nanoparticules.

8. Procédé selon l'une quelconque des revendications 1 à 7, **caractérisé en ce que** les nanoparticules mises à dispositions sont façonnées de manière irrégulière.

9. Procédé selon l'une quelconque des revendications 1 à 8, **caractérisé en ce que** les nanoparticules mises à disposition présentent une extension maximale de 1 - 1000 nanomètres.

10. Procédé selon l'une quelconque des revendications 1 à 9, **caractérisé en ce que** les nanoparticules mises à disposition ont une forme sphérique, cubique, de barre, de fil ou la forme d'un tétrapode.

11. Procédé selon l'une quelconque des revendications 1 à 10, **caractérisé en ce qu'**avant de former la couche moléculaire sur la surface des nanoparticules, on homogénéise le système colloïdal.

12. Procédé selon la revendication 11, **caractérisé en ce que** l'homogénéisation s'effectue au moyen d'ultrasons.

13. Procédé selon l'une quelconque des revendications 1 à 12, **caractérisé en ce qu'**on mélange au système colloïdal des nanoparticules poreuses et/ou creuses.

14. Procédé selon la revendication 13, **caractérisé en ce que** les nanoparticules sont constituées de SiO₂, de TiO₂, d'Al₂O₃, de verre ou de quartz.
